Europäisches Patentamt

(19) European Patent Office (11) Veröffentlichungsnummer: **0 104 469**

Office européen des brevets **B1**

(12) **EUROPÄISCHE PATENTSCHRIFT**

(45) Veröffentlichungstag der Patentschrifft: (51) Int. Cl. ⁴: **H 03 M 3/04**
**17.01.90**

(21) Anmeldenummer: **83108502.2**

(22) Anmeldetag: **29.08.83**

(54) **Digitaler DPCM-Kodierer mit hoher Verarbeitungsgeschwindigkeit.**

(30) Priorität: **01.09.82 DE 3232558**

(43) Veröffentlichungstag der Anmeldung:
**04.04.84 Patentblatt 84/14**

(45) Bekanntmachung des Hinweises auf die Patenterteilung:
**17.01.90 Patentblatt 90/03**

(84) Bennante Vertragsstaaten:
**AT BE CH DE FR GB IT LI NL SE**

(56) Entgegenhaltungen:
**EP-A-0 021 948**
**DE-A-2 260 264**
**DE-A-2 354 088**

(73) Patentinhaber: **Siemens Aktiengesellschaft**
**Wittelsbacherplatz 2**
**D-8000 München 2 (DE)**

(72) Erfinder: **Grallert, Hans-Joachim, Dr.-Ing.**
**Tannenfleckstrasse 30**
**D-8038 Gröbenzell (DE)**

LIBERGRAF, STOCKHOLM 1990

EP 0 104 469 B1

**Beschreibung**

Die Erfindung betrifft einen digitalen DPCM-Kodierer für hohe Verarbeitungsgeschwindigkeiten nach dem Oberbegriff des Patentanspruches 1.

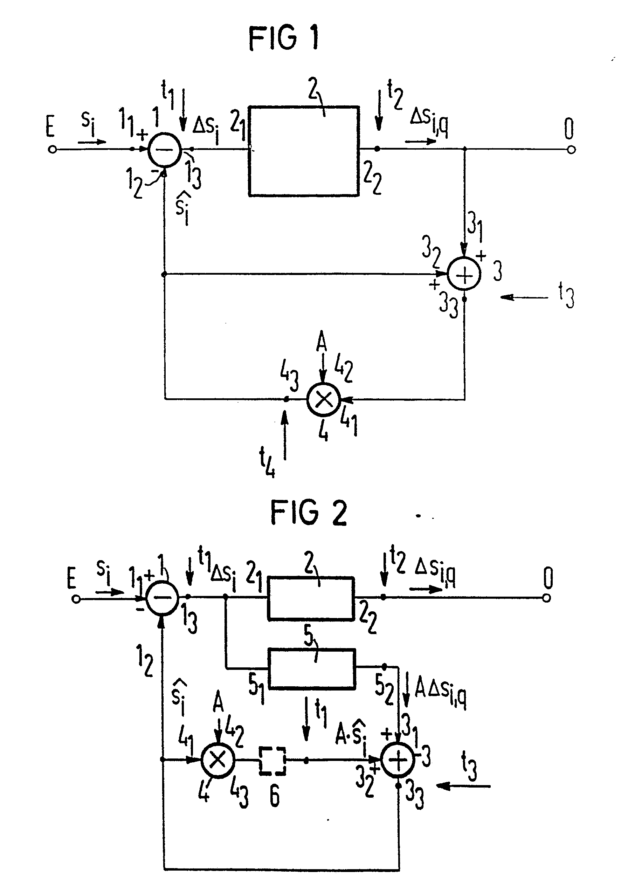

In Fig. 1 ist ein bekannter DPCM-Kodierer dargestellt, der jeweils einen DPCM-Signalwert in vier Rechenschritten ermittelt. Dies sind eine Subtraktion, eine Quantisierung, eine Addition und eine Prädiktion. Die Addition und die Prädiktion werden in einer Rechenschleife durchgeführt, die einen Addierer und einen Prädiktor - hier einen Multiplizierer - enthält. Die Funktion des bekannten DPCM-Kodierers wird später noch näher erläutert. Bei hohen Übertagungsgeschwindigkeiten bedingt dieser bekannte Aufbau jedoch auch bei einsatzmoderner Schaltungstechnik zu lange Rechenzeiten.

Ein solcher DPCM-Kodierer ist in Fig. 3 der europäischen Patentanmeldung EP-A-0 021 948 dargestellt. Da nur die Verarbeitung des letzten am Ausgang des Quantisierers abgegebenen quantisierten DPCM-Signalwertes zeitkritisch ist, kann sich die betrachtungsweise auf einen Multiplizierer als Prädiktor beschränken. Der hier dargestellte DPCM-Kodierer weist noch einen Quantisierer-Kodierer auf, dessen Eingang parallel zu dem des Quantisierers liegt und der kodierte DPCM-Signalwerte abgibt. An der eigentlichen Berechnung der DPCM-Signalwerte ist er jedoch nicht beteiligt. Üblicherweise wird ein Kodierer an den Ausgang des Quantisierers angeschaltet, um dieselbe Funktion zu erreichen.

Aufgabe der Erfindung ist es, einen DPCM-Kodierer anzugeben, der mit einer geringeren Anzahl aufeinanderfolgenden Rechenoperation in der Rückkopplungsschleife arbeitet.

Ausgehend von einem DPCM-Kodierer der eingangs beschriebenen Art, wird diese Aufgabe durch die im kennzeichnenden Teil des Anspruchs 1 angegebenen Merkmale gelöst.

Der erfindungsgemäße DPCM-Kodierer kommt mit nur drei Rechenschritten aus. Der Schaltungsaufwand ist hierbei nur unwesentlich größer. Es muß lediglich ein zweiter Quantisierer verwendet werden.

Es ist vorteilhaft, daß statt zweier Quantisierer ein einziger Quantisierer mit zwei Ausgängen vorgesehen ist.

Bei der Verwendung von integrierter Schalkreistechnik ist es zweckmäßig, beide Quantisierer gemeinsam zu realisieren.

Es ist aus Aufwandsgründen vorteilhaft, daß statt des ersten Quantisierers ein zweiter Multiplizierer vorgesehen ist, der an den Ausgang des zweiten Quantisierers angeschaltet ist, und daß durch den zweiten Multiplizierer eine Multiplikation mit dem Kehrwert 1/A des Prädiktionsfaktors erfolgt.

Bei dieser Schaltungsversion wird der erste Quantisierer durch Errechnen des quantisierten DPCM-Signals mittels eines zweiten Multiplizierers ersetzt.

Es ist zweckmäßig, daß als Quantisierer ein frei adressierbarer Speicher vorgesehen ist.

Als Speicher wird zweckmäßigerweise ein ROM, PROM oder ein EPROM verwendet. Ebenfalls ist ein RAM geeignet, in das die quantisierten DPCM-Werte vorher eingeschrieben werden. Die Quantisierung erfolgt in einer besonders einfachen Weise. An beispielsweise einem ROM liegt das im Subtrahierer errechnete DPCM-Signal als Adresse an. Hierdurch wird das quantisierte DPCM-Signal im allgemeinen mit einer geringeren Anzahl von Binärstellen ausgelesen. Die Quantisierung wird somit durch das Festlegen der Daten in dem ROM bewirkt.

Weitere vorteilhafte Ausbildungen der Erfindung sind in den übrigen Unteransprüchen angegeben.

Ein Ausführungsbeispiel der Erfindung wird anhand der Fig. 1 und 2 erläutert.

Es zeigen:

Fig. 1   einen bekannten DPCM-Kodierer und
Fig. 2   einen erfindungsgemäßen DPCM-Kodierer.

Der in Fig. 1 dargestellte DPCM-Kodierer enthält einen Subtrahierer 1, dessen Eingang $1_1$ den Eingang E der Schaltungsanordnung dargestellt. Der Ausgang $1_3$ des Subtrahierers 1 ist mit dem Eingang $2_1$ des Quantisierers 2 verbunden, dessen Ausgang $2_2$ den Ausgang O des DPCM-Kodierers darstellt, an dem das quantisierte DPCM-Signal $\Delta s_{i,q}$ abgegeben wird. Der Ausgang des Quantisierers 2 ist mit einem ersten Eingang $3_1$ eines Addierers 3 verbunden, dessen Ausgang $3_3$ mit dem ersten Eingang $4_1$ eines Multiplizierers 4 verbunden ist, dessen Ausgang $4_3$ mit dem zweiten Eingang $1_2$ des Subtrahierers und dem zweiten Eingang $3_2$ des Addierers 3 verbunden ist. Dem zweiten Eingang $4_2$ des Multiplizierers ist ein konstanter Prädiktionsfaktor $A \leq 1$ zugeführt. Dem Eingang der Schaltung werden PCM-Signalwerte $s_i$ zugeführt. Durch den Index "i" wird die zeitliche Reihenfolge der Signale gekennzeichnet.

Die Arbeitsweise des DPCM-Kodierers besteht darin, aus vorhergehenden Abtastwerten einen Schätzwert $\hat{s}_i$ zu errechnen. Aus der Differenz des anliegenden PCM-Signalwertes $s_i$ und dem Schätzwert $\hat{s}_i$ errechnet sich die Differenz $\Delta s_i$, die zunächst quantisiert und dann übertragen wird. Dieser quantisierte DPCM-Signalwert ist mit $\Delta s_{i,q}$ bezeichnet. Der zeitliche Ablauf der Berechnung eines DPCM-Signalwertes erfolgt in vier Schritten:

1) bis zum Zeitpunkt $t_1$: Berechnung von $\Delta s_i = s_i - \hat{s}_i$,

2) bis zum Zeitpunkt $t_2$: Quantisierung von $\Delta s_i \rightarrow \Delta s_{i,q}$,

3) bis zum Zeitpunkt $t_3$: Addition von $s_i + \Delta \hat{s}_{i,q}$,

4) bis zum Zeitpunkt $t_4$: Multiplikation: $A \cdot (s_i + \Delta s_{i,q}) = \hat{s}_{i+1})$

Die Darstellung des DPCM-Kodierers ist rein schematisch. Hier wurde angenommen, daß zu der Zeitpunkten $t_1$ bis $t_4$ jeweils das Ausgangssignal der Schaltungselemente anliegt. Dies kann durch die Wahl geeigneter Bausteine erfolgen oder aber durch zusätzliche Laufzeitglieder oder geeignete Zwischenspeicher (bistabile Kippstufen) erreicht werden.

Der erfindungsgemäße DPCM-Kodierer (Fig. 2) enthält ebenfalls einen Subtrahierer 1, dessen Ausgang $1_3$ mit dem Eingang $2_1$ des Quantisierers 2 verbunden ist, dessen Ausgang $2_2$ den Ausgang O des DPCM-Kodierers darstellt. Ein zweiter Quantisierer 5 ist mit seinem Eingang $5_1$ ebenfalls an den Ausgang $1_3$ des Subtrahierers angeschaltet. Der Ausgang $5_2$ des zweiten Quantisierers 5 ist mit dem ersten Eingang $3_1$ des Addierers 3 verbunden, dessen Ausgang $3_3$ mit dem zweiten Eingang des Subtrahierers verbunden ist.

Das an dem Eingang $1_2$ anliegende Signal wird von dem am Eingang E anliegenden PCM-Signalwert $s_i$ subtrahiert. Über den Multiplizierer 4 ist der Ausgang $3_3$ des Addierers 3 mit seinem zweiten Eingang $3_2$ verbunden. Bei einigen Lösungen ist es notwendig, dem Multiplizierer 4 ein Laufzeitglied 6 nachzuschalten. Aus den vorangegangenen Betrachtungen ergibt sich für die Berechnung des Schätzwertes:

$$\hat{s}_{i+1} = A(\hat{s}_i + \Delta\hat{s}_{i,q}) = A \cdot \hat{s}_i + A\Delta s_{i,q}.$$

Führt man die Bewertung mit dem Prädikationsfaktor A für $\hat{s}_i$ und $\Delta s_{i,q}$ getrennt durch, können einige Rechenoperationen in dem DPCM-Kodierer parallel ablaufen. Dies wird durch den zweiten Quantisierer 5 erreicht, an dessen Ausgang bereits das mit dem Prädiktionsfaktor A multiplizierte quantisierte DPCM-Signal $\Delta\hat{s}_{i,q}$ ausgegeben wird.

Der zeitliche Ablauf zur Berechnung von $\hat{s}_{i+1}$ kann nun in drei Zeitintervalle unterteilt werden:

1) bis zum Zeitpunkt $t_1$: Berechnung von $\Delta s_i = s_i - \hat{s}_i$ und $A \cdot \hat{s}_i$,

2) bis zum Zeitpunkt $t_2$: Bestimmung von $\Delta s_{i,q}$ und $A \cdot \Delta s_{i,q}$,

3) bis zum Zeitpunkt $t_3$: Addition: $A \cdot \Delta s_{i,q} + A \cdot \hat{s}_i = \hat{s}_{i+1}$.

In Fig. 2 sind die berechneten Werte nach den Zeitpunkt $t_2$ angegeben. Mit Hilfe dieser Schaltungsanordnung werden nur drei aufeinanderfolgende Rechenoperationen benötigt. Die pro Rechenoperation zur Verfügung stehende Zeit erhöht sich dadurch bzw. es kann eine schnellere Folge von PCM-Signalwerten $s_i$ verarbeitet werden.

Als Quantisierer werden bei dieser Schaltungsanordnung ROM's verwendet. Auch PROM's und RAM's sind möglich. Die Quantisierung erfolgt automatisch durch das Auslesen der gespeicherten Daten durch das am Eingang der Quantisierer anliegende DPCM-Signal $\Delta s_i$. Als Addierer und Multiplizierer können handelsübliche Bausteine verwendet werden, z. B. der Typ SN 54 LS181 als Addierer und Subtrahierer sowie der Baustein SN 54 LS261 als Multiplizierer. Diese Bausteine werden von der Firma Texas Instruments hergestellt.

**Patentansprüche**

1. Digitaler DPCM-Kodierer für hohe Verarbeitungsgeschwindigkeiten mit einem Subtrahierer (1), dessen erstem Eingang ($1_1$) ein PCM-Signal ($s_i$) und dessen zweitem Eingang ($1_2$) ein Schätzwert ($\hat{s}_i$) zugeführt wird, mit einem ersten an den Ausgang des Subtrahierers angeschalteten Quantisierer (2), an dessen Ausgang quantisierte DPCM-Signale abgegeben werden, mit einem ebenfalls an den Ausgang des Subtrahierers (1) angeschalteten zweiten Quantisierer (5) und mit einer Rechenschleife (3, 4) zur Ermittlung des Schätzwertes ($\hat{s}_i$), die einen Addierer (3), dessen erstem Eingang ($3_1$) der Ausgang ($2_2$) des zweiten Quantisierers zugeführt ist, und einen Multiplizierer (4) enthält, *dadurch gekennzeichnet, daß* der zweite Quantisierer (5) an seinem Ausgang ($5_2$) mit einem Prädiktionsfaktor (A) multiplizierte quantisierte DPCM-Signale ($A\Delta s_{i,q}$) abgibt, und daß der Ausgang ($3_3$) des Addierers (3) dem zweiten Eingang ($1_2$) des Subtrahierers (1) und dem ersten Eingang ($4_1$) des Multiplizierers (4) zugeführt ist, dessen Ausgang dem zweiten Eingang ($3_2$) des Addierers zugeführt ist.

2. Digitaler DPCM-Kodierer nach Anspruch 1, *dadurch gekennzeichnet, daß* statt zweier Quantisierer (2 und 5) ein einziger Quantisierer mit zwei Ausgängen vorgesehen ist, an denen die entsprechenden Signale abnehmbar sind.

3. Digitaler DPCM-Kodierer nach Anspruch 1, *dadurch gekennzeichnet, daß* statt des ersten Quantisierers (2) ein zweiter Multiplizierer vorgesehen ist, der an den Ausgang ($5_2$) des zweiten Quantisierers (5) angeschaltet ist und daß durch den zweiten Multiplizierer eine Multiplikation mit dem Kehrwert 1/A des Prädiktionsfaktors erfolgt.

4. Digitaler DPCM-Kodierer nach einem der vorhergehenden Ansprüche, *dadurch gekennzeichnet, daß* als Quantisierer (2, 5) ein frei adressierbarer Speicher (ROM, EPROM, PROM) vorgesehen ist.

5. Digitaler DPCM-Kodierer nach Anspruch 4, *dadurch gekennzeichnet, daß* sich die Information am Ausgang des zweiten Quantisierers (5) oder am entsprechenden Ausgang des einzigen Quantisierers nur nach einem neuen Arbeitstakt ändert.

6. Digitaler DPCM-Kodierer nach einem der vorhergehenden Ansprüche, *dadurch gekennzeichnet, daß* der Subtrahierer (1) durch einen Addierer mit vorgeschaltetem Komplementbildner ersetzt ist.

7. Digitaler DPCM-Kodierer nach einem dem vorhergehenden Ansprüche, *dadurch gekennzeichnet,* daß in Serie mit dem Multiplizierer (4) ein Laufzeitglied (6) geschaltet ist.

## Claims

1. Digital DPCM coder for high processing speeds having a subtractor (1), the first input ($1_1$) of which is fed with a PCM signal ($s_i$) and the second input ($1_2$) of which is fed with an estimated value ($\hat{s}_i$), having a first quantizer (2) which is connected to the output of the subtractor and at the output of which quantized DPCM signals are output, having a second quantizer (5) likewise connected to the output of the subtractor (1) and having an arithmetic loop (3, 4) for calculating the estimated value ($\hat{s}_i$), which loop contains an adder (3), the first input ($3_1$) of which is fed to the output ($2_2$) of the second quantizer, and a multiplier (4), characterized in that the second quantizer (5) outputs at its output ($5_2$) quantized DPCM signals ($A \cdot \Delta s_{i,q}$) multiplied by a prediction factor (A), and in that the output ($3_3$) of the adder (3) is fed to the second input ($1_2$) of the subtractor (1) and to the first input ($4_1$) of the multiplier (4), the output of which is fed to the second input ($3_2$) of the adder.

2. Digital DPCM coder according to Claim 1, characterized in that, instead of two quantizers (2 and 5), a single quantizer with two outputs is provided, at which the corresponding signals can be picked off.

3. Digital DPCM coder according to Claim 1, characterized in that, instead of the first quantizer (2), a second multiplier is provided which is connected to the output ($5_2$) of the second quantizer (5), and in that a multiplication with the reciprocal value 1/A of the prediction factor is carried out by the second multiplier.

4. Digital DPCM coder according to one of the preceding claims, characterized in that a freely addressable memory (ROM, EPROM, PROM) is provided as a quantizer (2, 5).

5. Digital DPCM coder according to Claim 4, characterized in that the information at the output of the second quantizer (5) or at the corresponding output of the single quantizer only changes after a new work cycle.

6. Digital DPCM coder according to one of the preceding claims, characterized in that the subtractor (1) is replaced by an adder with upstream complement former.

7. Digital DPCM coder according to one of the preceding claims, characterized in that a delay element (6) is connected in series with the multiplier (4).

## Revendications

1. Codeur MICD numérique pour des vitesses élevées de traitement, comportant un soustracteur (1), à la première entrée ($1_1$) duquel est envoyé un signal MIC ($s_i$) et à la seconde entrée ($1_2$) duquel est envoyée une valeur estimée ($\hat{s}_i$), un premier quantificateur (2), qui est raccordé à la sortie du soustracteur et à la sortie duquel sont prélevés des signaux MICD quantifiés, un second quantificateur (5) également raccordé à la sortie du soustracteur (1) et une boucle de calcul (3, 4) servant à déterminer la valeur estimée ($\hat{s}_i$) et contenant un additionneur (3), à la première entrée ($3_1$) duquel est raccordée la sortie ($2_2$) du second quantificateur, et un multiplicateur (4), caractérisé par le fait que le second quantificateur (5) délivre, sur sa sortie ($5_2$), des signaux MICD quantifiés ($A\Delta s_{i,q}$), multipliés par un facteur de prédiction (A), et que la sortie ($3_3$) de l'additionneur (3) est raccordée à la seconde entrée ($1_2$) du soustracteur (1) et à la première entrée ($4_1$) du multiplicateur (4), dont la sortie est raccordée à la seconde entrée ($3_2$) de l'additionneur.

2. Codeur MICD numérique suivant la revendication 1, caractérisé par le fait qu'à la place de deux quantificateurs (2 et 5), il est prévu un seul quantificateur comportant deux sorties, sur lesquels les signaux correspondants peuvent être prélevés.

3. Codeur MICD numérique suivant la revendication 1, caractérisé par le fait qu'à la place du premier quantificateur (2) il est prévu un second multiplicateur, qui est raccordé à la sortie ($5_2$) du second quantificateur (5) et que ce second multiplicateur effectue une multiplication avec la valeur l/A, inverse du facteur de prédiction.

4. Codeur MICD numérique suivant l'une des revendications précédentes, caractérisé par le fait qu'on prévoit, comme quantificateurs (2, 5), une mémoire librement adressable (ROM, EPROM, PROM).

5. Codeur MICD numérique suivant la revendication 4, caractérisé par le fait que l'information présente sur la sortie du second quantificateur (5) ou sur la sortie correspondante du quantificateur unique varie uniquement après un nouveau cycle de travail.

6. Codeur MICD numérique suivant l'une des revendications précédentes, caractérisé par le fait que le soustracteur (1) est remplacé par un additionneur, en amont duquel est branché un dispositif de formation de la valeur complémentaire.

7. Codeur MICD numérique suivant l'une des revendications précédentes, caractérisé par le fait qu'un circuit de retardement (6) est branché en série avec le multiplicateur (4).

# FIG 1

# FIG 2